# EUROPEAN PATENT APPLICATION

(11) **EP 4 354 521 A1**
(43) Date of publication of application: **17.04.2024**
(21) Application number: 23829727.9
(22) Date of filing: 11.05.2023
(51) Int. Cl.: H01L 31/048

(54) **SOLAR PANEL**

(30) Priority: 01.07.2022 CN 202210775387; 11.07.2022 CN 202221779611 U; 09.12.2022 CN 202223301238 U; 13.01.2023 CN 202320081870 U
(71) Applicant: Shenzhen Hello Tech Energy Co., Ltd, Shenzhen, Guangdong 518000 (CN)
(72) Inventor: YU, Huajun, Shenzhen, Guangdong 518000 (CN); ZHU, Yanjun, Shenzhen, Guangdong 518000 (CN); CHEN, Fengwen, Shenzhen, Guangdong 518000 (CN); ZHANG, Minhuan, Shenzhen, Guangdong 518000 (CN); SUN, Zhongwei, Shenzhen, Guangdong 518000 (CN)
(74) Representative: DehnsGermany Partnerschaft von Patentanwälten
(86) International application number: PCT/CN2023/093553
(87) International publication number: WO 2024/001541

(57) **Abstract**

Provided is a solar panel. The solar panel includes a rigid frame and a cell. The rigid frame has an accommodation opening. The cell is disposed at the accommodation opening.

## Description

### PRIORITY INFORMATION

This application claims a priority to Chinese Patent Application No. 202221779611.7 filed on July 11, 2022, No. 202210775387.2 filed on July 1, 2022, No. 202223301238.7 filed December 9, 2022, and No. 202320081870.0 filed on January 13, 2023 with China National Intellectual Property Administration, the entire contents of which are incorporated herein by reference.

### FIELD

The present disclosure relates to the field of solar energy technologies, and more particularly, to a solar panel.

### BACKGROUND

A solar panel is short for a solar cell panel, which is a core part of a solar power system. An operation principle of the solar panel is to generate power by absorbing sunlight and directly supply power to an application product, or charge a battery and then supply power to the application product from the battery.

### SUMMARY

Embodiments of the present disclosure provide a solar panel.

The solar panel according to embodiments of the present disclosure includes a cell configured to receive radiations and generate power.

The solar panel according to an embodiment includes a rigid frame and a cell. The rigid frame has an accommodation opening, and the cell is disposed at the accommodation opening.

The solar panel according to the embodiment internally has the rigid frame and a power generation module composed of the cell. The power generation module composed of the cell is configured to receive light radiations and generate power. The cell is disposed at the accommodation opening of the rigid frame. The rigid frame can protect the cell in an encapsulating direction, and thus can improve impact resistance, bending resistance, and mechanical strength. Meanwhile, compared with a traditional external metal frame, the rigid frame is lighter in weight, and can reduce a shielding of the edges. Therefore, an operation of the cell cannot be interfered.

In some embodiments, the solar panel includes at least one power generation assembly and a wire. Each of the at least one power generation assembly includes the rigid frame, the cell, a back plate, and an insulation plate. The rigid frame has the accommodation opening. The cell is disposed at the accommodation opening. The back plate is disposed at the accommodation opening and located on the cell. An adhesive film is arranged between the back plate and the cell. The insulation plate covers an end surface of the rigid frame close to the back plate. The wire is arranged between the back plate and the insulation plate.

The solar panel according to the embodiment includes the at least one power generation assembly and the wire. Each of the at least one power generation assembly includes the rigid frame, the cell, the back plate, and the insulation plate. The rigid frame has the accommodation opening. The cell and the back plate are both disposed at the accommodation opening. The back plate is disposed at a side of the cell close to the back film. The insulation plate covers the end surface of the rigid frame close to the back plate. The wire is arranged between the back plate and the insulation plate. In the solar panel according to the embodiment of the present disclosure, by additionally providing the insulation plate and arranging the wire between the back plate and the insulation plate, the wire can be better protected, and thus power leakage due to an exposure of the wire can avoided. Therefore, safety of the solar panel can be improved.

In some embodiments, the solar panel includes the rigid frame, a cell layer, a front plate layer, and a back plate layer. The rigid frame has the accommodation opening. The cell layer is disposed at the accommodation opening. The front plate layer is located at a side of the cell layer. The back plate layer is located at an opposite side of the cell layer.

The solar panel according to the embodiment internally has the rigid frame and a power generation module composed of the cell layer, the front plate layer, and the back plate layer. The cell layer is configured to receive light radiations and generate power. The front plate layer and the back plate layer can respectively protect the cell layer from a front side and a back side. The cell layer power generation module is disposed at the accommodation opening of the rigid frame. The rigid frame can protect the cell in an encapsulating direction, and thus can improve impact resistance, bending resistance, and mechanical strength. Meanwhile, compared with a traditional external metal frame, the rigid frame is lighter in weight, and can reduce a shielding of the edges. Therefore, an operation of the cell layer cannot be interfered.

In some embodiments, the solar panel includes a cell layer, at least one glass fiber reinforcement layer, and two protective layers that are stacked together. The two protective layers are respectively arranged at two sides of the cell layer. The at least one glass fiber reinforcement layer is arranged between the cell layer and one of the two protective layers. The glass fiber reinforcement layer is made by mixing glass fiber and an impregnated adhesive. Each of the at least one glass fiber reinforcement layer and the protective layers has a transparent structure.

According to the embodiment, the glass fib reinforcement layer is arranged between one of the two protective layer and the cell layer. The cell layer is configured to receive light radiations and generate power. Each of the two protective layer is configured to protect an inner layer structure. Each of the glass fiber reinforcement layer and the protective layers has the transparent structure, which avoid influence on an operation of the cell layer. The glass fiber reinforcement layer is made by mixing the glass fiber and the impregnated adhesive. On the one hand, the glass fiber reinforcement layer can improve impact resistance of the cell layer and bending resistance of the solar panel. On the other hand, since each of the glass fiber and the impregnated adhesive for forming the glass fiber reinforcement layer has a small density, influence on a weight of the solar panel is less, and portability of the solar panel can be ensured.

In some embodiments, the solar panel includes a battery layer, and a front plate and a back plate that are respectively stacked at a front side and a back side of the battery layer. The battery layer includes the rigid frame and a battery string. The rigid frame includes a plurality of vertical frame bars and a plurality of horizontal bars. The plurality of vertical frame bars are cross-connected to the plurality of transverse frame bars to define a plurality of accommodation openings. The battery string includes a plurality of cells accommodated at the accommodation openings. The plurality of vertical frame bars is detachably connected to the plurality of transverse frame bars.

According to the solar panel of the embodiment, the rigid frame is arranged between the front plate and the back plate, and the battery string is disposed at the accommodation openings of the rigid frame. The rigid frame has a high support strength, and thus damage to the battery string due to bending deformation of the solar panel can be reduced, thereby protecting the battery string and improving the mechanical strength without more layers and adding the glass fiber material. As a result, an overall weight and costs can be lowered. The rigid frame is composed of the plurality of the vertical frame bars and the plurality of the transverse frame bars that are detachably connected to each other. Compared with an integrated frame structure, the solar panel not only has lower production costs, but also is easy to be assembled with products of different shapes, size, and thicknesses. Therefore, the solar panel has higher flexibility in use.

Additional aspects and advantages of the present disclosure will be given at least in part in the following description, or become apparent at least in part from the following description, or can be learned from practicing of the present disclosure.

### BRIEF DESCRIPTION OF THE DRAWINGS

The above and/or additional aspects and advantages of the present disclosure will become more apparent and more understandable from the following description of embodiments taken in conjunction with the accompanying drawings, in which:
FIG. 1 is a cross-sectional exploded view of a solar panel according to an embodiment of the present disclosure.
FIG. 2 is a top view of a solar panel according to an embodiment of the present disclosure.
FIG. 3 is an enlarged view of part A in FIG. 2.
FIG. 4 is a schematic structural exploded view of a solar panel according to a first embodiment of the present disclosure.
FIG. 5 is a schematic structural exploded view of a solar panel according to a second embodiment of the present disclosure.
FIG. 6 is a schematic structural exploded view of a solar panel according to a third embodiment of the present disclosure.
FIG. 7 is a schematic structural exploded view of a solar panel according to a fourth embodiment of the present disclosure
FIG. 8 is a schematic structural exploded view of a solar panel according to a fifth embodiment of the present disclosure.
FIG. 9 is a schematic structural exploded view of a solar panel according to a sixth embodiment of the present disclosure.
FIG. 10 is a schematic structural exploded view of a solar panel according to a seventh embodiment of the present disclosure.
FIG. 11 is a schematic structural exploded view of a solar panel according to an eighth embodiment of the present disclosure.
FIG. 12 is a schematic structural exploded view of a solar panel according to a ninth embodiment of the present disclosure.
FIG. 13 is a schematic structural exploded view of a solar panel according to a tenth embodiment of the present disclosure.
FIG. 14 is a schematic structural exploded view of a solar panel according to the present disclosure.
FIG. 15 is a schematic diagram of a structure of a battery layer according to the present disclosure.
FIG. 16 is a schematic diagram of a structure of a rigid frame according to the present disclosure.
FIG. 17 is an enlarged view of part B in FIG. 16.
FIG. 18 is a schematic structural view of a battery string according to the present disclosure.
FIG. 19 is a schematic structural exploded view of a battery layer according to the present disclosure.

### Reference Numerals:

1100, power generation assembly; 1200, wire;1300, front film; 1400, back film; 1500, insulation film; 1600, adhesive film; 1700, bendable region; 1800, handle structure;
11, rigid frame; 111, first edge; 112, second edge; 113, third edge; 114, fourth edge;
12, cell;
13, back plate;
14, insulation plate;
15, front plate.
21, cell layer; 211, cell; 22, front plate layer; 221, front plate unit; 23, back plate layer; 231, back plate unit; 24, rigid frame; 241, accommodation opening; 25, front film layer; 26, back film layer; 27, first encapsulation adhesive film; 271, sub-encapsulation adhesive film; 28, second encapsulation adhesive film.
31, cell layer; 311, cell; 32, glass fiber reinforcement layer; 321, glass fiber reinforcement units3321; 33, protective layer; 34, carrying layer; 35, rigid frame; 351, accommodation opening; 36, encapsulation adhesive film;
4100, rigid frame; 4110, vertical frame bar; 4111, inner vertical frame bar; 4112, side vertical frame bar; 4120, transverse frame bar; 4121, inner transverse frame bar; 4122, side transverse frame bar; 4130, accommodation opening; 4141, first mortise-tenon portion; 4142, second mortise-tenon portion;
4200, battery string; 4201, cell; 4202, welding strip; 4203, vertical gap; 4204, transverse gap;
4300, front plate; 4400, back plate; 4500, adhesive film.

### DETAILED DESCRIPTION

The embodiments of the present disclosure will be described in detail below with reference to examples thereof as illustrated in the accompanying drawings, throughout which same or similar elements are denoted by same or similar reference numerals.

In addition, the embodiments described below with reference to the drawings are illustrative merely, and are intended to explain, rather than limiting, the present disclosure.

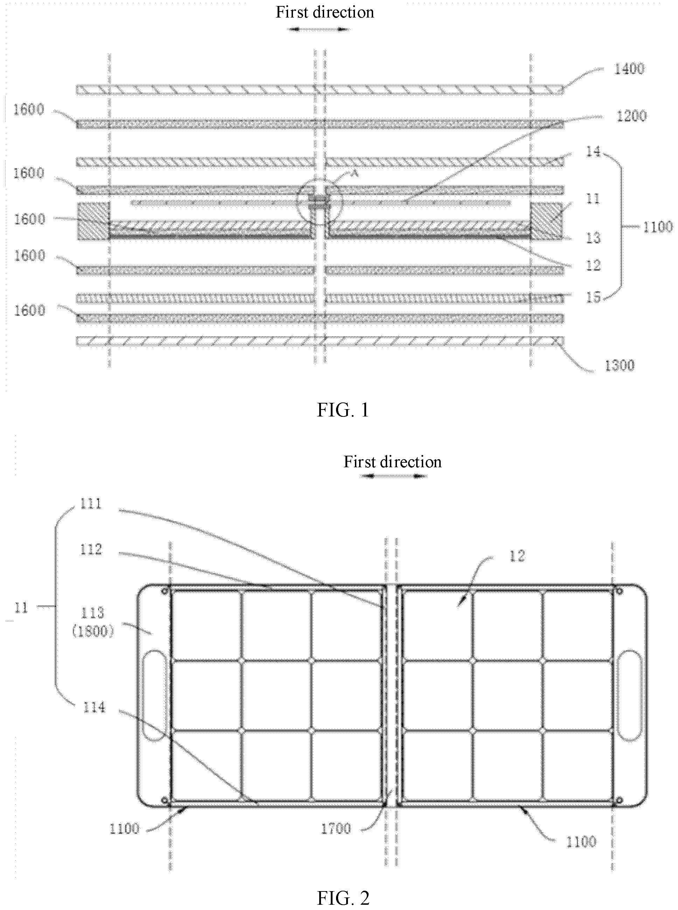

FIG. 1 illustrates a cross-sectional exploded view of a solar panel according to an embodiment of the present disclosure. As shown in FIG. 1, the solar panel includes a rigid frame 11 and a cell 12. The rigid frame11 has an accommodation opening, and the cell 12 is arranged at the accommodation opening.

According to the embodiment of the present disclosure, the cell 12 of the solar panel is disposed at the accommodation opening of the rigid frame 11. The rigid frame 11 can protect the cell 12 in an encapsulating direction, and thus can improve impact resistance, bending resistance, and mechanical strength. Meanwhile, compared with a traditional external metal frame, the rigid frame is lighter in weight, and can reduce a shielding of the edges. Therefore, an operation of the cell 12 cannot be interfered.

FIG. 1 illustrates the cross-sectional exploded view of the solar panel according to an embodiment the present disclosure. As shown in FIG. 1, the solar panel includes at least one power generation assembly 1100 and a wire 1200. The wire 1200 is configured to electrically connect the at least one power generation assembly 1100. Each of the at least one power generation assembly 1100 includes a rigid frame 11, a cell 12, a back plate 13, an insulation plate 14, and a front plate 15. The rigid frame 11 has an accommodation opening. The cell 12 and the back plate 13 are arranged at the accommodation opening. The back plate 13 is arranged at a side of the cell 12 close to the back film 1400. An adhesive film 1600 is arranged between the back plate 13 and the cell 12. The insulation plate 14 covers an end surface of the rigid frame 11 close to the back plate 13. The front plate 15 covers an end surface of the rigid frame 11 close to the cell 12. The wire 1200 is arranged between the back plate 13 and the insulation plate 14. In the solar panel according to the embodiment of the present disclosure, by additionally providing the insulation plate 14 and arranging the wire 1200 between the back plate 13 and the insulation plate 14, the wire 1200 can be better protected, and thus power leakage due to an exposure of the wire can avoided. Therefore, safety of the solar panel can be improved.

The front plate 15 may be made of an insulating transparent material of mechanical toughness, such as polyethylene terephthalate (PET) and PET composites, or a thin glass. In this way, a solar energy conversion rate of the power generation assembly 1100 can be improved to meet power demand of users.

The back plate 13 may be made of a support material of mechanical toughness, such as a glass fiber plate, the PET and PET composites, and the thin glass. In this way, the back plate can support the cell 12 to better protect the cell 12.

The insulation plate 14 may be made of an anti-puncture material of mechanical strength, such as the glass fiber plate, and the PET and PET composites. In this way, it is possible to prevent the broken wire 1200 from puncturing the insulation plate 14, and thus power leakage of the solar panel can be avoided.

FIG. 2 illustrates a top view of a solar panel according to the embodiment of the present disclosure. As shown in FIG. 1 in connection with FIG. 2, the solar panel further includes a front film 1300 and a back film 1400. The at least one power generation assembly 1100 comprises at least two power generation assemblies 1100 that are arranged between the front film 1300 and the back film 1400 at intervals in a first direction. A space between two adjacent power generation assemblies 1100 is formed as a bendable region 1700 on the front film 1300 and the back film 1400. The wire 1200 is configured to electrically connect the two adjacent power generation assemblies 1100. The solar panel can be foldable at the bendable region 1700 formed between two adjacent power generation assemblies 1100, contributing to folding and storing the solar panel for easily carrying and transporting the solar panel, which can thus meet outdoor travel requirements of users.

The front film 1300 is made of a transparent flexible material selected from fluorine-containing materials such as ethylene-tetra-fluoro-ethylene (ETFE), polyvinylidene difluoride (PVDF), Poly(vinyl formal) (PVF), ethylene-chlorotrifluoroethylene copolymer (ECTFE), and the like. These materials have characteristics of aging resistance and can prolong a service life of the solar panel. Further, the back film 1400 is made of a transparent flexible material selected from the fluorine-containing materials such as ETFE, PVDF, PVF, ECTFE, and the like. These materials have the characteristic of aging resistance and can prolong the service life of the solar panel. In addition, the back film 1400 may also be made of an opaque cloth material.

An adhesive film 1600 is arranged between the front film 1300 and the front plate 15 to increase connection strength between the front film 1300 and the front plate 15. An adhesive film1600 is arranged between the back film 1400 and the insulation plate 14 to increase connection strength between the back film 1400 and the insulation plate 14.

Referring to FIG. 2, the cell 12 is a plurality of battery cells arranged in a rectangular matrix pattern. The battery cells and the cell 12 are electrically connected to each other by the wires 1200. The cells 12 are connected in series and parallel by the wires 1200.

Continuing to refer to FIG. 2, the solar panel further includes two handle structures 1800. The two handle structures 1800 are located at two ends of the at least two power generation assemblies 1100 in the first direction. With such handle structures 1800, the user can carry the solar panel when the solar panel is folded. Therefore, user experience can be improved.

Further, each of the handle structures 1800 has a gripping groove. Each of the front film 1300 and the back film 1400 has a through groove corresponding to the gripping groove. A shape of the through groove matches with a shape of the gripping groove. The user can carry the solar panel directly by means of the gripping grooves.

Continuing to refer to FIG. 2, the rigid frame 11 is formed by enclosing with a plurality of edges that is detachably assembled. In this way, the rigid frame 11 can be detachably connected. In an exemplary embodiment, the rigid frame 11 includes a first edge 111, a second edge 112, a third edge 113, and a fourth edge 114. The first edge 111 and the third edge 113 are spaced apart from each other in parallel along the first direction. The second edge 112 and the fourth edge 114 are spaced apart from each other in parallel. Two ends of the first edge 111 are detachably connected to the second edge 112 and the fourth edge 114 respectively, and two ends of the third edge 113 are detachably connected to the second edge 112 and the fourth edge 114 respectively. In some embodiments, the rigid frame 11 is of a square shape. In this case, and lengths of the first edge 111, the second edge 112, the third edge 113, and the fourth edge 114 are the same, and thus mass production can be realized and a universality of parts can be improved.

In FIG. 2, the rigid frame 11 of the power generation assembly 1100 located at an end in the first direction and the handle structure 1800 are integrally formed. For example, the handle structure 1800 and an edge of the rigid frame 11 are integrally formed. In other embodiments, the handle structure 1800 may also fixedly connected to an edge of the rigid frame 11 adjacent to the handle structure 1800.

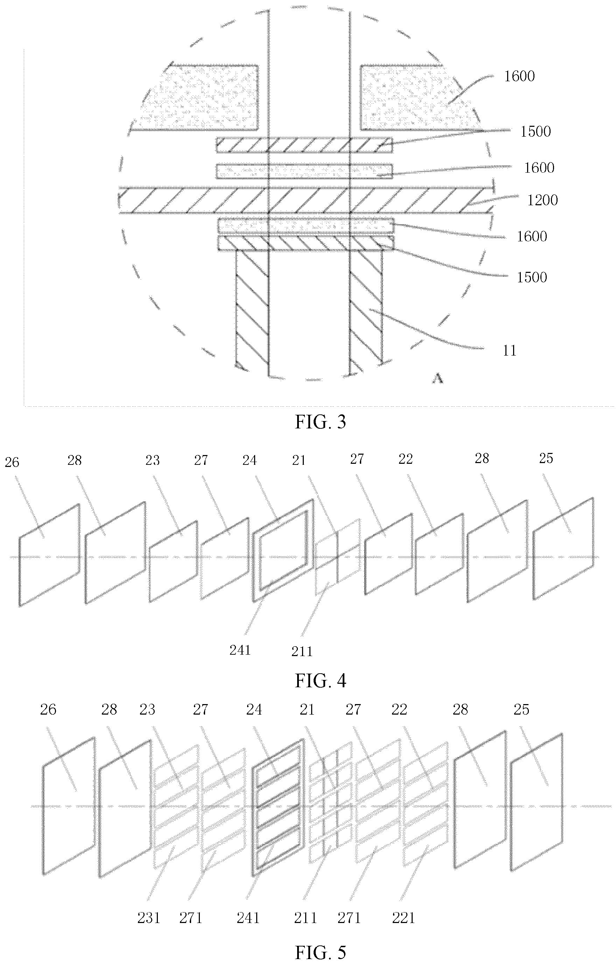

After the solar panel is repeatedly folded and unfolded at the bendable region 1700, a part of the wire 1200 located at the bendable region 1700 is prone to be broken or fractured. FIG. 3 shows an enlarged view at part A in FIG. 2. As shown in FIG. 3 in connection with FIG. 2, the solar panel further includes an insulation film 1500. The part of the wire 1200 located at the bendable region 1700 is covered with the insulation film 1500. The insulation film 1500 at least partially extends to an adjacent back plate 13 and an adjacent insulation plate 14. In this way, power leakage due to the breakage of the wire1200 can be avoided. The insulation film 1500 may be made of PET film or cloth with an insulation coating.

In some embodiments, two sides of the part of the wire 1200 located in the bendable region 1700 are covered with the insulation film 1500. In this way, the two sides of the wire 1200 can be better protected, and thus it is possible to prevent the front film 1300 and the back film 1400 from being punctured due to the broken wire 1200. Therefore, power leakage of the solar panel can be avoided.

The part of the wire1200 located in the bendable region 1700 is made of scattered braided copper wires to reduce a bending force applied to the wire 1200 in the bendable region 1700, which can prolong a service life of the wire 1200 and avoid the power leakage due to the puncture of the front film 1300 or the back film 1400 by the broken wire 1200.

As shown in FIG. 4, a solar panel according to a first embodiment of the present disclosure includes a power generation module and a rigid frame 24. The rigid frame 24 has a frame structure. The rigid frame 24 has an accommodation opening 241, and the power generation module is disposed at the accommodation opening 241. The power generation module includes a cell layer 21, a front plate layer 22, and a back plate layer 23 that are stacked together. The cell layer 21 is arranged between the front plate layer 22 and the back plate layer 23. Each of the front plate layer 22 and the back plate layer 23 has a transparent structure.

In an exemplary embodiment, the solar panel of the embodiment is internally provided with a rigid frame 24 and a power generation module composed of a cell layer 21, a front plate layer 22, and a back plate layer 23. The cell layer 21 is configured to receive light radiations and generate power. The front plate layer 22 and the back plate layer 23 can protect the cell layer 21 from a front side and a back side, respectively. The cell layer 21 is disposed at the accommodation opening 241 of the rigid frame 24. The rigid frame 24 can protect the cell layer 21 in an encapsulating direction, and thus can improve impact resistance, bending resistance, and mechanical strength. Meanwhile, compared with a traditional external metal frame, the rigid frame is lighter in weight, and can reduce a shielding of the edges. Therefore, an operation of the cell layer 21 cannot be interfered.

In some embodiments, the entire power generation module is accommodated at the accommodation opening 241 as a whole. That is, the front plate layer 22, the cell layer 21 and the back plate layer r23 are all accommodated at the accommodation opening 241.

In some embodiments, the cell layer 21 includes at least two cells 211. The front plate layer 22 includes a front plate unit 221, and the back plate layer 23 includes a back plate unit 231. The accommodation opening 241 is formed at the rigid frame 24. A sub-power generation module includes the cell 211, the front plate unit 221, and the back plate unit 231 that are stacked together. At least one sub-power generation module correspondingly has one accommodation openings 241. In this embodiment, the cell layer 21 includes four cells 211 arranged in a matrix pattern. An integrated front plate unit 221 and an integrated back plate unit 231 are respectively arranged at a front surface and a back surface of the four cells 211. In an exemplary embodiment, when the solar panel has a small size (generally less than 0.1 m²), the rigid frame24 is designed into a single accommodation opening structure, and the sub-power generation modules are disposed in the single accommodation opening 241 of the rigid frame 24.

In some embodiments, the cell layer 21 includes a plurality of double-sided crystalline silicon chips. Each of the cells 211 is provided with the double-sided crystalline silicon chip. The double-sided crystalline silicon chip can receive light radiations from two opposite sides and generating power. Therefore, power generation per unit weight of the cell layer 21 can be increased.

In some embodiments, the rigid frame 24 is made of a high temperature resistant polymer material or a metal material such as a polyimide polymer, an aromatic polyamide polymer, an aluminum alloy. In this way, the rigid frame 24 has a lighter weight than a traditional external metal frame and the double-sided operation of the cell 211 would not be interfered while improving impact resistance, bending resistance and mechanical strength. When mounting the solar panel, the cell 211 can be laminated after being correspondingly disposed at the accommodation opening 241. In this case, the integrated can be omitted and manufacturing is simple.

In some embodiments, the rigid frame 24 has a thickness greater than or equal to a thickness of the cell layer 21, which can improve protection reliability.

In some embodiments, the thickness of the rigid frame 24 is greater than or equal to a thickness of the power generation module, which can further improve the protection reliability.

In some embodiments, the thickness of the rigid frame 24 ranges from 0.5mm to 3mm, and a width of the rigid frame 24 ranges from 5mm to 30 mm.

In some embodiments, each of the front plate layer 22 and the back plate layer 23 is made of a transparent polymer material or an ultra-thin glass such as polycarbonate (PC), polyester resin (PET), or PET film material containing a coating layer. The front plate layer 22 and the back plate layer 23 may also be made of a transparent flexible material with good mechanical strength, such as expandable polyethylene (EPE), composite phenolic foam (FPF), double-sided fluorine-containing back plate (KPK).

In some embodiments, the thickness of each of the front plate layer 22 and the back plate layer 23 range from 0.2 mm to 1 mm.

In some embodiments, the solar panel further includes a front film layer 25 and a back film layer 26. The front film layer 25 and the back film layer 26 are respectively attached to a front surface and a back surface of the power generation module. In one embodiment, the front film layer 25 is arranged at a side of the front plate layer 22 away from the cell layer 21, and the back film layer26 is arranged at a side of the back plate layer 23 away from the cell layer 21.each of the front film layer 25 and the back film layer 26 has a transparent structures for protecting the inner power generation module.

In some embodiments, the front film layer 25 and the back film layer 26 are made of a fluorine-containing film material such as ethylene-tetrafluoroethylene copolymer(ETFE), ethylene-chlorotrifluoroethylene copolymer (ECTFE).

In some embodiments, the front film layer 25 and the back film layer 26 are made of a same material. In one embodiment, the back film layer 26 is made of polyester resin (PET) with a predetermined mechanical strength, which can better bond the sub-power generation modules in the rigid frame 24 and provide supporting and better edge protection.

In some embodiments, the front plate layer 22 and the back plate layer 23 are respectively bonded to the cell layer 21 by a first encapsulation adhesive film 27. The front film layer 25 and the back film layer 26 are respectively bonded to the power generation module by a second encapsulation adhesive film 28.

Further, the front film layer 25 and its corresponding the second encapsulation adhesive film 28 are subjected to physical embossing at a high temperature, and the back film layer 26 and its corresponding the second encapsulation adhesive film 28 are subjected to physical embossing at a high temperature. As a result, rough surfaces are respectively formed on the front film layer 25 and the back film layer 26. On the one hand, the rough surfaces serves as a light trapping structure, and on the other hand, the rough surfaces can protect the inner layer structure in the solar panel from being scratched. In addition, it is possible to assist in limiting the cell layer 21 to confine the cell 211 at the accommodation opening 241 of the rigid frame 24.

In some embodiments, the first encapsulation adhesive film 27 and the second encapsulation adhesive film 28 may be made of EVA plastic, POE plastic, polyvinyl butyral (PVB), thermoplastic polyolefin (TPO) or benzoyl peroxide (BPO). Each of the first encapsulation adhesive film 27 and the second encapsulation adhesive film 28 has a colorless and transparent structure.

A solar panel according to a second embodiment of the present disclosure will be described below. As shown in FIG. 5, the solar panel according to the second embodiment differs from that of the first embodiment. In the present embodiment, the power generation module of this embodiment includes at least two sub-power generation modules. The front plate layer 22 includes at least two front plate units 221.The back plate layer 23 includes at least two back plate units 231. Each of the sub-power generation modules has an elongated structure extending transversely. Further, each of the sub-power generation modules has a plurality of cells 211. Each of the front plate units 221 and each of the back plate units 231 correspondingly has an elongated structure. Two adjacent sub-power generation modules are arranged side by side. The number of the accommodation openings 241 is equal to the number of the sub-power generation modules. The accommodation openings 241 correspondingly have elongated structures side by side. In this embodiment, three sub power generation modules and three accommodation openings 241 are provided.

In some embodiments, the power generation module is divided into a plurality of sub-power generation modules, and each of the plurality of sub-power generation modules is disposed at the accommodation openings 241 of the rigid frame 24 in one-to-one correspondence. In this way, a size of each front plate unit 221 and each back plate unit 231 can be reduced. As a result, bending and deformation of the front plate unit 221 and the back plate unit 231 of large size can be avoided. The front plate unit 221 and the back plate unit 231 can be compatible with more materials such as ultra-thin glass. Further, since the ultra-thin glass has high flatness, a rigidity of the glass can improve impact resistance of the front surface and the back surface of the cell, thereby improving bending resistance of the solar panel.

In other embodiments, two or more self-generating modules may also be disposed at the accommodation opening 241 of the rigid frame 24.

In some embodiments, the first encapsulation adhesive film 27 includes a plurality of sub-encapsulation adhesive films 271, and the plurality of sub-encapsulation adhesive films 271 are constructed into an elongated structure matching with each of the front plate unit 221 and the back plate unit 231. The front plate unit 221 and the back plate unit 231 are respectively bonded to the cell 211 by the corresponding sub-encapsulation adhesive film 271.

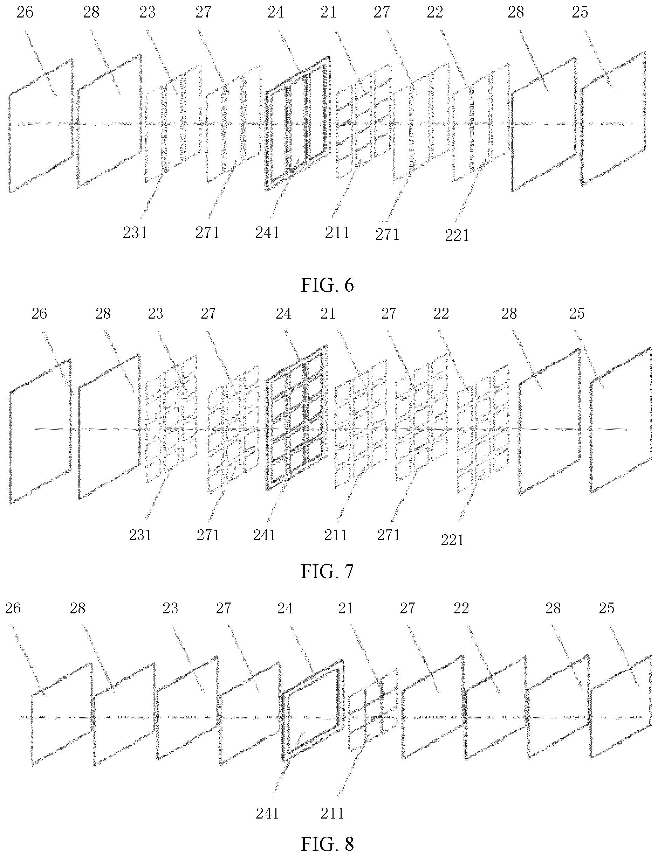

A solar panel according to a third embodiment of the present disclosure will be described below. As shown in FIG. 6, the solar panel according to this embodiment is different from that of the second embodiment. In the present embodiment, the sub-power generation modules are constructed into an elongated structure extending vertically. The accommodation openings 241 are correspondingly formed into an elongated structure extending vertically and arranged in parallel.

A solar panel according to a fourth embodiment of the present disclosure will be described below. As shown in FIG. 7, the solar panel according to this embodiment is different from that of the fourth embodiment. In the present embodiment, at least four sub-power generation modules are provided. The number of each of the cells 211, the front plate units 221, and the back plate units 231 is equal to the number of the self-generating modules. The sub-generating modules are arranged in a matrix pattern, and the accommodation openings 241 are correspondingly arranged in the matrix pattern. In this embodiment, fifteen sub-power generation modules are provided.

In some embodiments, each of the sub-power generation modules includes a cell 211, a front plate unit 221, and a back plate unit 231. In this way, it is possible to further reduce the size of each front plate unit 221 and each back plate unit 231.

In some embodiments, the first encapsulation adhesive film 27 includes a plurality of sub-encapsulation adhesive films 271 arranged in a matrix pattern. The front plate unit 221 and the back plate unit 231 are respectively bonded to cell 211 by the corresponding sub-encapsulation adhesive films 271.

A solar panel according to a fifth embodiment of the present disclosure will be described below. As shown in FIG. 8, the solar panel according to this embodiment is different from that of the first embodiment. In the present embodiment, the rigid frame 24 is located between the front plate layer 22 and the back plate layer 23. The front plate layer 22 and the back plate layer 23 are respectively arranged on a front side and a back side of the rigid frame 24 as whole plate structure. That is, only the cell layer 21 is disposed at the accommodation opening 241, and the front plate layer 22 and the back plate layer 23 are not disposed at the accommodation opening 241. In this way, the protection to the cell layer 21 can be realized.

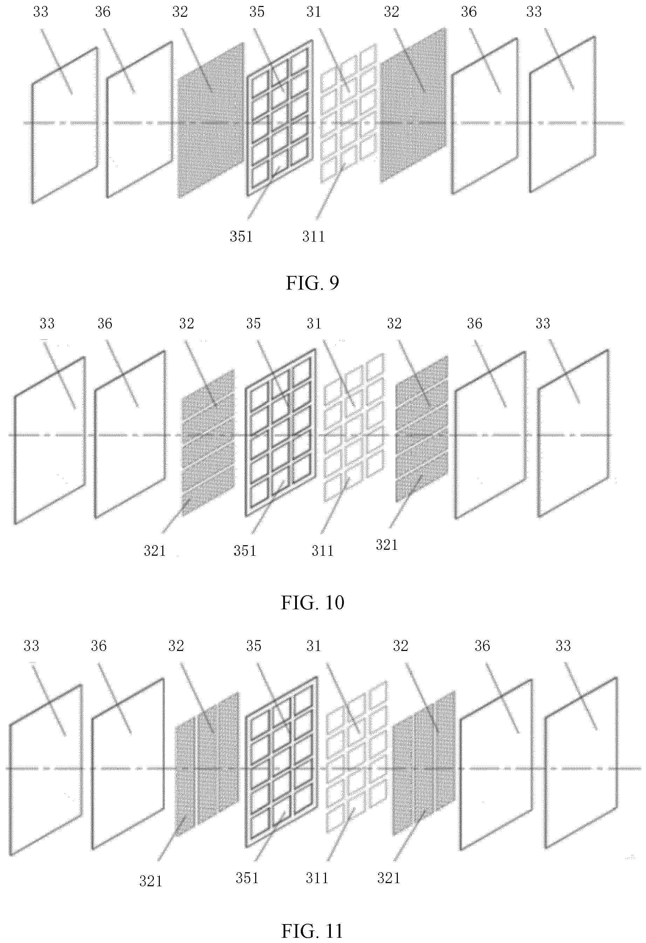

A solar panel according to a sixth embodiment of the present disclosure will be described below. As shown in FIG. 9, according to the sixth embodiment, a solar panel is provided. The solar panel includes a cell layer 31, at least one glass fiber reinforcement layer 32, and two protective layers 33 that are stacked together. Two protective layers 33 are respectively arranged at two sides of the cell layer 31. The glass fiber reinforcement layer 32 is arranged between the cell layer 31 and one of the two protective layers 33. Each of the at least one glass fiber reinforcement layer 32 is made by mixing glass fiber and an impregnated adhesive. Each of the at least one glass fiber reinforcement layer 32 and the protective layers 33 has a transparent structure.

In an exemplary embodiments, in the solar panel according to the present embodiment, the at least one glass fiber reinforcement layer 32 is arranged between one of the two protective layer 33 and the cell layer 31. The cell layer 31 is configured to receive light radiations and generate power. The protective layer 33 is configured to protect an inner layer structure. The glass fiber reinforcement layer 32 subjected to high-temperature hot pressing is transparent. The protective layer 33 also has a transparent structure to allow for transmission without affecting an operation of the cell layer 31. The glass fiber reinforcement layer 32 is made by mixing the glass fiber and the impregnated adhesive. On the one hand, the glass fiber reinforcement layer 32 can improve impact resistance of the cell layer 31 and bending resistance of the solar panel. On the other hand, since each of the glass fiber and the impregnated adhesive for forming the glass fiber reinforcement layer 32 has a small density, influence on self-weight of the solar panel is less, and portability of the solar panel can be ensured. In addition, the glass fiber reinforcement layer 32 can initially fix the cell layer 31 due to its predetermined viscosity. Therefore, it is possible to prevent the cell layer 31 from being displaced during a laminating operation.

In some embodiments, two glass fiber reinforcement layers 32 is provided. The two glass fiber reinforcement layers 32 are respectively arranged at two sides of the cell layer 31. The two glass fiber reinforcement layers 32 can enhance the impact resistance of the cell layer 31 respectively from two sides, thereby further improving the impact resistance.

In some embodiments, the glass fiber reinforcement layer 32 is constructed into an integrated mesh structure.

In some embodiments, the impregnated adhesive includes at least one of EVA (ethylene vinyl acetate copolymer) plastic, POE (high polymer of ethylene and butene, or high polymer of ethylene and octene) plastic, and polyester resin.

In some embodiments, the cell layer 31 includes a plurality of double-sided crystalline silicon chips. The plurality of double-sided crystalline silicon chips is capable of receiving light radiations from two opposite sides and generating power, and thus amount of power generation per unit weight of that cell layer 31 can be improved.

In some embodiments, the cell layer 31 includes a plurality of cells 311. Each of the plurality of the cells 311 has a double-sided crystalline silicon chip. The solar panel further includes a rigid frame 35. The rigid frame 35 is constructed into a frame structure. The rigid frame 35 has a plurality of accommodation openings 351 arranged in a matrix pattern. The accommodation openings 351 are configured to accommodate the cells 311. The rigid frame 35 is made of a high temperature resistant polymer material or a metal material such as polyimide polymer, aromatic polyamide polymer, or aluminum alloy. The rigid frame 35 can protect the cell layer 31 in an encapsulating direction, and thus impact resistance, bending resistance, and mechanical strength can be improved. Meanwhile, compared with a traditional external metal frame, the rigid frame is lighter in weight, and can reduce a shielding of the edges. Therefore, a double-sided operation of the cell 311 cannot be interfered. When mounting the solar panel, the cells 311 is correspondingly disposed at the accommodation opening 351 and then is laminated. In this case, the integrated frame can be omitted and manufacturing is simple.

In some embodiments, the rigid frame 35 has a thickness great than or equal to a total thickness of the plurality of cells 311.

In some embodiments, the thickness of the rigid frame 35 ranges from 0.5 mm to 3 mm, and a width of the rigid frame 35 ranges from 5 mm to 30 mm.

In some embodiments, the glass fiber reinforcement layer 32 and the protective layer 33 are bonded to each other by an encapsulation adhesive film 36.

Further, the protective layer 33 and its corresponding encapsulation adhesive film 36 are subjected to physical embossing at a high temperature. As a result, a rough surface is formed on the protective layer 33. On the one hand, the rough surface serves as a light trapping structure, and on the other hand, the rough surfaces can protect the inner layer structure in the solar panel from being scratched. In addition, it is possible to assist in limiting the cell layer 31 to confine the cell 311 at the accommodation opening 351 of the rigid frame 35.

In some embodiments, the protective layer 33 is made of a fluorine-containing film material such as ETFE (ethylene-tetrafluoroethylene copolymer), ECTFE (ethylene-chlorotrifluoroethylene copolymer).

In some embodiments, the encapsulation adhesive film 36 may be made of EVA plastic, POE plastic, PVB (polyvinyl butyral), TPO (thermoplastic polyolefin) or BPO (benzoyl peroxide). The encapsulation adhesive film 36 has a colorless transparent structure.

A solar panel according to a seventh embodiment of the present disclosure will be described below. As shown in FIG. 10, the solar panel according to this embodiment is different from that of the first embodiment. In the present disclosure, the glass fiber reinforcement layer 32 includes at least two glass fiber reinforcement units 321 arranged side by side. Each of the glass fiber reinforcement units 321 is constructed into an elongated mesh structure extending horizontally, which can reduce a molding difficulty of the glass fiber reinforcement layer 32. In this embodiment, three glass fiber reinforcement units 321 are provided.

A solar panel according to an eighth embodiment of the present disclosure will be described below. As shown in FIG. 11, the solar panel according to this embodiment is different from that of the first embodiment. In the present embodiment, the glass fiber reinforcement layer 32 includes at least two glass fiber reinforcement units 321 arranged side by side. Each of the glass fiber reinforcement units 321 is constructed into an elongated mesh structure extending longitudinally, which reducing a molding difficulty of the glass fiber reinforcement layer 32. In this embodiment, three glass fiber reinforcement units 321 are provided.

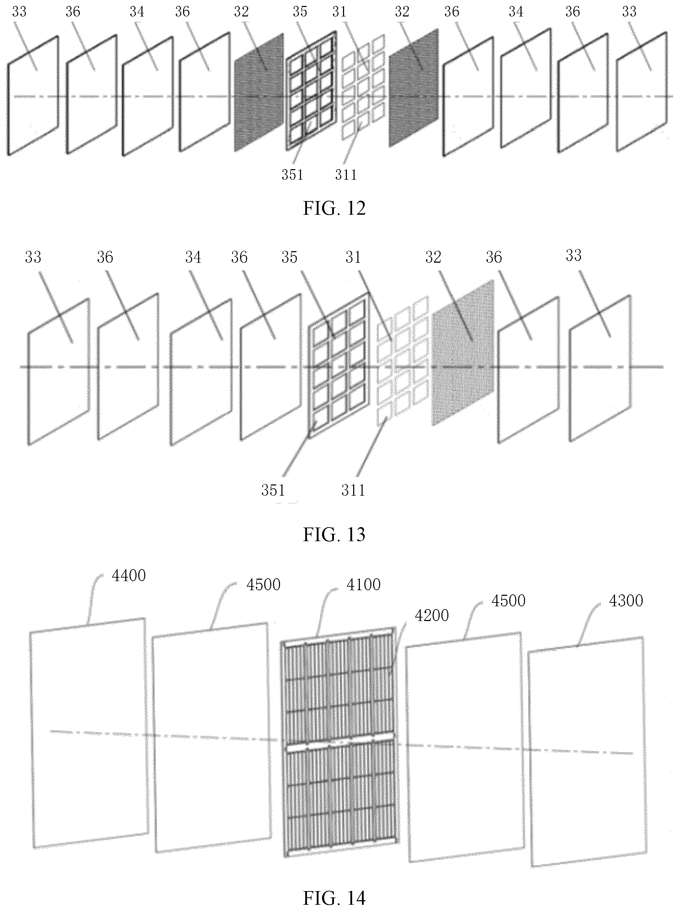

A solar panel according to a ninth embodiment of the present disclosure will be described below. As shown in FIG. 12, the solar panel according to this embodiment is different from the first solar panel. In the present embodiment, the solar panel further includes two carrying layers 34. The carrying layers 34 are made of a transparent polymer material. The two carrying layers 34 are respectively arranged between the two glass fiber reinforcement layers 32 and the protective layer 33. The glass fiber reinforcement layer 32 and the protective layer 33 are respectively bonded to the carrying layers 34 by an encapsulation adhesive film 36. The arrangement of the carrying layer 34 can further enhance the mechanical strength of the solar panel.

In some embodiments, the carrying layer 34 is made of PC (polycarbonate), PET, or a PET film material containing a coating layer, or the carrying layer 34 may also be made of a transparent flexible material with good mechanical strength, such as EPE (expandable polyethylene), FPF (compounded phenolic foam), KPK (double-sided fluorine-containing back plate).

In some embodiments, the carrying layer 34 has a thickness ranging from 0.2 mm to 1 mm.

A solar panel according to a tenth embodiment of the present disclosure will be described below. As shown in FIG. 13, the solar panel according to this embodiment is different from the second solar panel. In the present embodiment, one glass fiber reinforcement layer 32 and one carrying layer 34 are provided in the solar panel. The glass fiber reinforcement layer 32 and the carrying layer 34 are respectively arranged at a front side and a back side of the cell layer 31. The carrying layer 34 is arranged between the cell layer 31 and the protective layer 33. The rigid frame 35 and the protective layer 33 are respectively bonded to the carrying layer 34 by the encapsulation adhesive film 36.

In the solar panel according to the embodiments, as shown in FIG. 14 to FIG. 19, the solar panel includes a battery layer, and a front plate 4300 and a back plate 4400 respectively stacked at a front side and a back side of the battery layer. The battery layer includes a rigid frame 4100 and a battery string 4200. The rigid frame 4100 includes a plurality of vertical frame bars 4110 and a plurality of horizontal bars 4120. The plurality of the vertical frame bars 4110 and the plurality of the transverse frame bars 4120 are cross-connected to define a plurality of accommodation openings 4130. The battery string 4200 includes a plurality of cells 4201. The cells 4201 are disposed at the accommodation openings 4130. The vertical frame bars 4110 and the transverse frame bars 4120 are detachably connected to each other.

In some embodiments, according to the solar panel of this embodiment, the hard rigid frame 4100 is arranged between the front plate 4300 and the back plate 4400, and the battery string 4200 is disposed at the accommodation openings 4130 of the rigid frame 4100. The rigid frame 4100 has a high support strength, and thus damage to the battery string 4200 due to bending deformation of the solar panel can be reduced, thereby protecting the battery string 4200 and improving the mechanical strength without more layers and adding the glass fiber material. As a result, an overall weight and costs can be lowered. The rigid frame 4100 is composed of the plurality of the vertical frame bars 4110 and the plurality of the transverse frame bars 4120 that are detachably connected to each other. Compared with an integrated frame structure, the solar panel not only has lower production costs, but also is easy to be assembled with products of different shapes, size, and thicknesses, therefore, the solar panel has higher flexibility in use.

Illustratively, each of the plurality of the vertical frame bars 4110 and each of the plurality of the transverse frame bars 4120 has a thickness greater than or equal to a thickness of the battery string 4200. In this way, surface strength of the solar panel can be enhanced. In this embodiment, the thickness of each of the plurality of the vertical frame bars 4110 and the plurality of the transverse frame bars 4120 is greater than the thickness of the battery string 4200. Thus, it is possible to prevent a normal force from being applied to the battery string 4200.

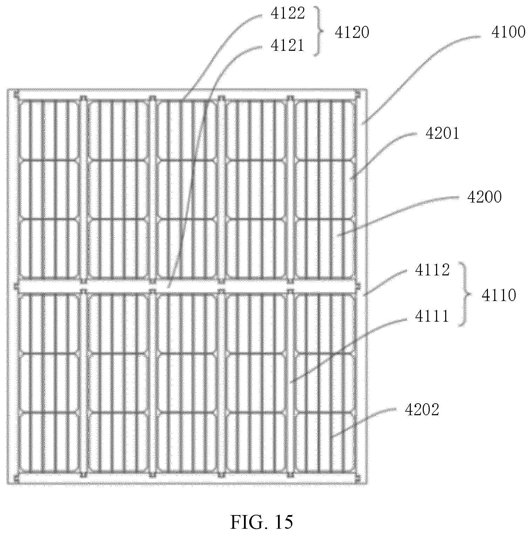

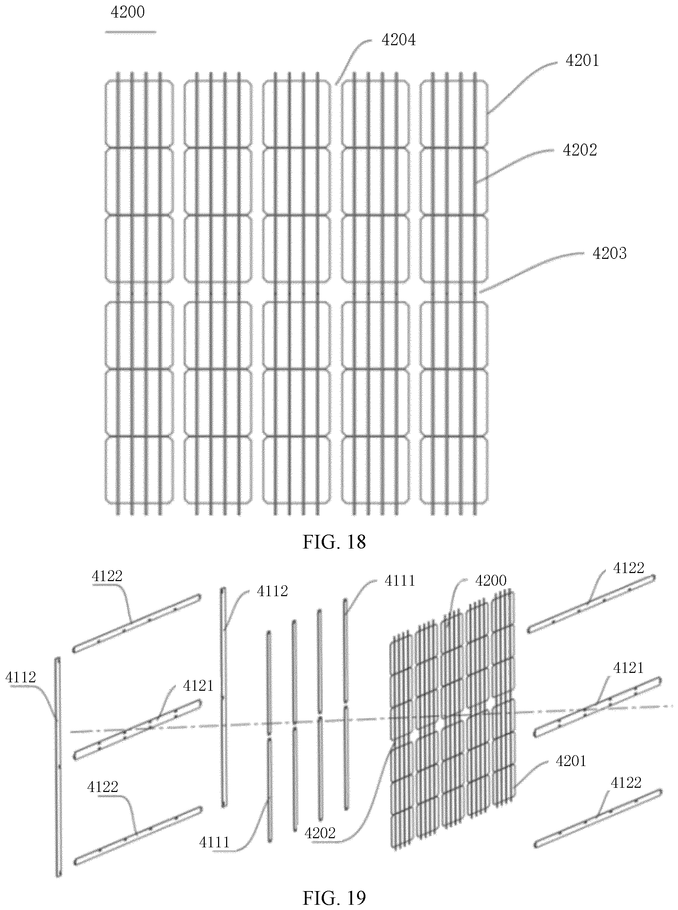

Illustratively, as shown in FIG. 15 and FIG. 18, the plurality of the cells 4201 is arranged in a matrix pattern. A transverse gap 4204 is formed between the cells 4201 arranged in two vertically adjacent accommodation openings 4130, and a vertical gap 4203 is formed between cells 4201 arranged in two horizontally adjacent accommodation openings 4130. In this embodiment, three cells 4201 arranged vertically are disposed in each of the accommodation openings 4130. The three cells 4201 in one accommodation opening 4130 are formed as a sub-battery string. Ten accommodation openings 4130 is formed, and the ten accommodation openings 4130 are evenly arranged in upper and lower layers. In this case, there is one transverse gap 4204 and eight vertical gaps 4203.

Illustratively, as shown in FIG. 15 and FIG. 18, the battery string 4200 further includes a welding strip 4202. The welding strip 4202 electrically connects adjacent cells 4201 in a vertical direction. Further, the welding strip 4202 passes through the transverse gap 4204.

Illustratively, the vertical frame bars 4110 include several inner vertical frame bars 4111 and two side vertical frame bars 4112 that are transversely arranged side by side. The inner vertical frame bars 4111 are disposed at the vertical gaps 4203. The two side vertical frame bars 4112 are arranged side by side at a left side and a right side of the inner vertical frame bars 4111. The side vertical frame bars 4112 are located at a left and a right side of the battery string 4200 to wrap the left and right sides of battery string 4200, thereby protecting the left and right sides of the solar panel.

Illustratively, the transverse frame bars 4120 include several inner transverse frame bars 4121 and at least two side transverse frame bars 4122 that are arranged vertically side by side. At least one of the inner transverse frame bars 4121 is disposed at the transverse gaps 4204. The two side transverse frame bars 4122 are arranged side by side at an upper side and a lower side of the inner transverse frame bars 4121. The side transverse frame bars 4122 are located at an upper side and a lower side of battery string 4200 to wrap the upper and lower sides of battery string 4200, thereby protecting the upper and lower sides of the solar panel.

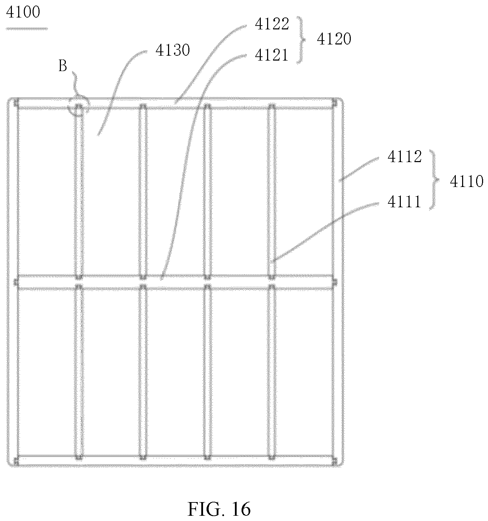

In this embodiment, as shown in FIG. 16 and FIG. 19, the number of inner longitudinal frame bars corresponds to the number of the longitudinal gaps, and thus eight inner longitudinal frame bars are provided. In this case, one inner longitudinal frame bar is disposed at one longitudinal gap.

Illustratively, as shown in FIG. 19, two inner transverse frame bars 4121 are disposed at one transverse gap 4204. The two inner transverse frame bars 4121 are stacked. Further, the two inner transverse frame bars 4121 are spaced apart from each other. A welding strip 4202 vertically passes through the gap between the two inner transverse frame bars 4121. Since the welding strip 4202 can pass through the gap between the two inner transverse frame bars 4121, an edge damage or a desoldering of the welding strip 4202 due to pulling of the cells 4201 when the welding strip 4202 passes through the inner transverse frame bars 4121. Meanwhile, the inner transverse frame bars 4121 can shield a current collecting wire connected to the welding strip 4202. Therefore, the solar panel has a neat and orderly appearance.

Illustratively, as shown in FIG. 19, two side transverse frame bars 4122 are respectively provided on the upper side and the lower side of the battery string 4200. The two side transverse frame bars 4122 on one side are stacked. Further, the two side transverse frame bars 4122 are spaced apart from each other. The welding strip 4202 vertically passes through a gap between the two side transverse frame bars 4122. The welding strip 4202 passes through the gap between the two side transverse frame bars4122, which can reduce an edge damage or a desoldering of the welding strip 4202 due to pulling of the cell 4201 when the welding strip 4202 passes through the side transverse frame bars 4122. Meanwhile, the side transverse frame bars 4122 can shield a current collecting wire connected to the welding strip 4202. Therefore, the solar panel has a neat and orderly appearance.

In other embodiments of the present disclosure, the transverse gap 4204 may also be provided for the inner transverse frame bars 4121 of a single layer, and each of side transverse frame bars 4122 at the upper sides and the lower sides of the battery string 4200 may also be a side transverse frame bar of a single layer. A thickness of each of the inner transverse frame bar 4121 and the side transverse frame bar 4122 is smaller than a thicknesses of each of the inner vertical frame bar 4111 and the side vertical frame bar 4112. In this way, the welding strip 4202 can be easily pulled, and thus it is possible to provide more room for the current collecting wire.

Illustratively, each of the inner transverse frame bar 4121 and the side transverse frame bars 4122 is constructed into an elongated thin plate-like structure. The thicknesses of each of the inner transverse frame bar 4121 and the side transverse frame bar 4122 is smaller than each of the thickness of the inner vertical frame bar 4111 and the side vertical frame bar 4112.

Illustratively, the inner transverse frame bar 4121 and side transverse frame bar 4122 have the same thickness, and the inner vertical frame bar 4111 and side vertical frame bar 4112 have the same thickness.

Illustratively, the inner transverse frame bar 4121, the side transverse frame bar 4122, the inner vertical frame bar 4111, and the side vertical frame bar 4112 have different thicknesses.

In this embodiment, a width of the vertical gap 4203 ranges from 25 mm to 35 mm, and a width of the transverse gap 4204 ranges from 35 mm to 45 mm. The side vertical frame bar 4112 has a thickness of 3 mm and a width of 30 mm. The inner vertical frame bar 4111 has a thickness of 3 mm and a width ranging from 25 mm to 35mm. A thickness of the side transverse frame bar 4122 located below the welding strip 4202 is 1.2 mm, and a thickness of the side transverse frame bar 4122 located above the welding strip 4202 is 1.6 mm. A width of each of the side transverse frame bars 4122 is 30 mm. A thickness of the inner transverse frame bar 4121 located below the welding strip 4202 is 1.2 mm, and a thickness of the inner transverse frame bar 4121 located above the welding strip 4202 is 1.6 mm. A width of each of the inner transverse frame bars 4121 ranges from 35 mm to 45 mm.

Illustratively, the sub-battery string is spaced apart from the vertical frame bar 4110 and the transverse frame bar 4120. In this way, it is possible to reduce undesirable risks of fragmentation of the cells 4201 or poor lamination due to a non-uniform local pressure caused by a height difference during the lamination.

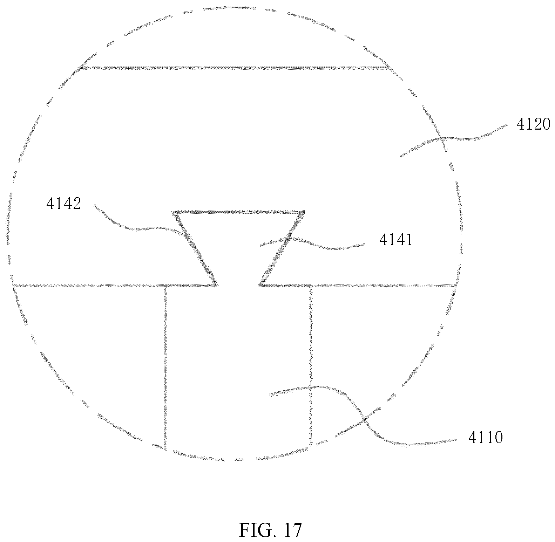

Illustratively, as shown in FIG. 17, the vertical frame bar 4110 is provided with a first mortise-tenon portion 4141, and the transverse frame bar 4120 is provided with a second mortise-tenon portion 4142, and/or the transverse frame bar 4120 is provided with a first mortise-ten portion 4141, and the vertical frame bar 4110 is provided with a second mortise-ten portion 4142. The first mortise-tenon portion 4141 and the second mortise-tenon portion4142 are connected to each other in a tenon-mortise manner. In this way, it is possible to allow for easy mounting and ensure reliability of the connection. In other embodiments, the vertical frame bar 4110 and transverse frame bar 4120 may also be detachably connected by other connection manner, for example, by a snap.

In this embodiment, as shown in FIG. 17, the first mortise-tenon portion 4141 is constructed as a trapezoidal protrusion, and a long bottom side of the trapezoidal protrusion is arranged to face outwards. The second mortise-tenon portion 4142 is correspondingly constructed as a trapezoidal recess matching with the trapezoidal protrusion, and a long bottom side of the trapezoidal groove is arranged to face inwards.

Illustratively, a peripheral edge of each of the side vertical frame bars 4112 and side transverse frame bars 4122 has a chamfer for reducing stress at the edges and corners when being impacted by external forces.

Illustratively, the vertical frame bars 4110 and/or transverse frame bars 4120 has a mounting hole(s). The front plate 4300, the back plate 4400 and/or external components are connected to each other by passing a fastener through the mounting hole. In this way, on the one hand, an adhesive bonded structure of a flexible board can be removed, and an air circulation channel under the solar panel can be formed, which can improve a heat dissipation performance and power generation efficiency of the solar panel. On the other hand, it is convenient to connect external components such as handles and brackets. Therefore, a compactness of the structure can be improved.

Illustratively, as shown in FIG. 14, the solar panel further includes an adhesive film 4500. The front plate 4300 and/or the back plate 4400 are respectively bonded and fixed to the battery layer by the adhesive film 4500.

Illustratively, the rigid frame 4100 is made of a fiberboard with high mechanical strength or a metal plate with surface insulation treatment.

Illustratively, the front plate 4300 is made of a material selected from transparent insulating materials with high mechanical toughness such as PET (polyethylene terephthalate) and PET composites.

Illustratively, the back plate 4400 is made of a material selected from support material with high mechanical toughness such as glass fiber sheet, PET and PET composite materials.

Illustratively, the adhesive film 4500 is made of a photovoltaic conventional material such as EVA (ethylene vinyl acetate copolymer), POE (Poly Olefin Elastomer), PO (propylene oxide), PVB (polyvinyl butyral).

Although explanatory embodiments have been illustrated and described, it would be appreciated that the above embodiments are exemplary and cannot be construed to limit the present disclosure. In addition, changes, modifications, alternatives and varieties can be made in the embodiments by those skilled in the art without departing from scope of the present disclosure. The scope of the present disclosure shall be defined by the claims as appended and their equivalents.

## Claims

**1.** A solar panel, comprising:
a rigid frame having an accommodation opening; and
a cell disposed at the accommodation opening.

**2.** The solar panel according to claim 1, comprising:
at least one power generation assemblies (1100), each of the at least one power generation assemblies (100) comprising:
the rigid frame (11) having the accommodation opening;
the cell (12) disposed at the accommodation opening;
a back plate (13) disposed at the accommodation opening and located on the cell (12), an adhesive film (1600) being arranged between the back plate (13) and the cell (12); and
an insulation plate (14) covering an end surface of the rigid frame (11) close to the back plate (13); and
a wire (1200) arranged between the back plate (13) the insulation plate (14).

**3.** The solar panel according to claim 2, further comprising a front film (1300) and a back film (1400), wherein:
the at least one power generation assemblies (1100) comprise at least two power generation assemblies that are arranged between the front film (1300) and the back film (1400) at intervals in a first direction;
a space between two adjacent power generation assemblies (1100) is formed as a bendable region (1700) on the front film (1300) and the back film (1400); and
the wire (1200) is configured to electrically connect the two adjacent power generation assemblies (1100).

**4.** The solar panel according to claim 3, further comprising an insulation film (1500), wherein:
a part of the wire (1200) located in the bendable region (1700) is covered with the insulation film (1500); and
the insulation film (1500) at least partially extends to an adjacent back plate (13) and an adjacent insulation plate (14).

**5.** The solar panel according to claim 4, wherein two sides of the part of the wire (1200) located in the bendable region (1700) are both covered with the insulation film (1500).

**6.** The solar panel according to claim 3, wherein the rigid frame (11) is formed by enclosing with a plurality of edges that is detachably assembled.

**7.** The solar panel according to claim 6, further comprising two handle structures (1800) located at two ends of the at least two of the power generating assemblies (1100) in the first direction.

**8.** The solar panel according to claim 7, wherein:
each of the two handle structures (1800) is fixedly connected to the rigid frame (11) adjacent to the handle structure (1800); or
each of the two handle structures (1800) and an edge of the rigid frame (11) adjacent to the handle structure (1800) are integrally formed.

**9.** The solar panel according to claim 8, wherein:
each of the two handle structures (1800) has a gripping groove; and
each of the front film (1300) and the back film (1400) has a through groove corresponding to the gripping groove, a shape of the through groove matching with a shape of the gripping groove.

**10.** The solar panel according to claim 3, wherein:
the front film (1300) is made of a transparent flexible material; and/or
the back film (1400) is made of a transparent flexible material.

**11.** The solar panel according to any one of claims 2 to 10, wherein each of the at least one power generation assembly (1100) further comprises a front plate (15) covering an end surface of the rigid frame (11) close to the cell (12), wherein:
an adhesive film (1600) is arranged between the front plate (15) and the rigid frame (11); and
an adhesive film (1600) is arranged between the insulation plate (14) and the rigid frame (11).
each of the at least one glass fiber reinforcement layer (32) and the protective layers (33) has a transparent structure.

**24.** The solar panel according to claim 23, wherein the at least one glass glass fiber reinforcement layers (32) comprises two fiber reinforcement layers (32) arranged at two sides of the cell layer (31) respectively.

**25.** The solar panel according to claim 24, wherein:
the two glass fiber reinforcement layers (32) are formed into an integrated mesh structure; or
each of the two glass fiber reinforcement layer (32) comprises at least two glass fiber reinforcement units (321) arranged side by side, the glass fiber reinforcement units (321) being constructed into an elongated mesh structure extending transversely or longitudinally.

**26.** The solar panel according to claim 23, wherein the impregnated adhesive comprises at least one of Ethylene Vinyl Acetate (EVA) copolymer, Poly Olefin Elastomer (POE) plastic, and polyester resin.

**27.** The solar panel according to claim 23, further comprising a carrying layer (34) made of a transparent polymer material,
wherein the carrying layer (34) is arranged between the cell layer (31) and the protective layer (33) and/or between the glass fiber reinforcement layer (32) and the protective layers (33).

**28.** The solar panel according to claim 23, wherein:
the cell layer (31) comprises a plurality of cells (311); and
the rigid frame (35) is constructed into a frame structure.

**29.** The solar panel according to claim 28, wherein the rigid frame (35) has a thickness greater than or equal to a total thickness of the plurality of cells (311).

**30.** The solar panel according to any one of claims 23 to 29, wherein each of the protective layers (33) has a rough surface formed by high-temperature physical embossing, the rough surface serving as a light trapping structure and being capable of protecting an inner layer structure and assisting in limiting the cell layer (31).

**31.** The solar panel according to any one of claims 23 to 29, wherein the cell layer (31) comprises a plurality of double-sided crystalline silicon chips, each of the double-sided crystalline silicon chip being capable of receiving light radiations from two opposite sides of the double-sided crystalline silicon chip and generating power.

**32.** The solar panel according to any one of claims 23 to 29, wherein the glass fiber reinforcement layer (32) and the corresponding protective layer (33) are bonded to each other by an encapsulation adhesive film (36).

**33.** The solar panel according to claim 1, comprising a battery layer, and a front plate (4300) and a back plate (4400) that are respectively stacked at a front side and a back side of the battery layer, wherein:
the battery layer comprises the rigid frame (4100) and a battery string (4200), the rigid frame (400) comprising a plurality of vertical frame bars (4110) and a plurality of transverse frame bars (4120), the vertical frame bars (4100) being cross-connected to the transverse frame bars (4120) to define a plurality of accommodation openings (4130);
the battery string (4200) comprises a plurality of cells (4201) accommodated at the accommodation openings (4130); and
the plurality of vertical frame bars (4110) is detachably connected to plurality of the transverse frame bars (4120).

**34.** The solar panel according to claim 33, wherein:
the plurality of vertical frame bars (4110) comprises several inner vertical frame bars (4111) and two side vertical frame bars (4112), the inner vertical frame bars (4111) and the two side vertical frame bars (4112) being transversely arranged side by side, and the two side vertical frame bars (4112) being respectively arranged side by side at a left side and a right side of the inner vertical frame bars (4111); and/or
the plurality of transverse frame bars (4120) comprises several inner transverse frame bars (4121) and at least two side transverse frame bars (4122), the inner transverse frame bars (4121) and the at least two side transverse frame bars (4122) being vertically arranged side by side, the at least two side transverse frame bars (4122) being arranged side by side at an upper side and a lower side of the inner transverse frame bars (4121).

**35.** The solar panel according to claim 34, wherein the plurality of cells (4201) is arranged in a matrix pattern,
wherein a transverse gap (4204) is formed between the cells (4201) arranged at the vertically adjacent accommodation openings (4130), at least one of the inner transverse frame bars (4121) being located at the transverse gap (4204); and
wherein a vertical gap (4203) is formed between the cells (4201) arranged at the transversely adjacent accommodation openings (4130), at least one of the inner vertical frame bars (4111) being located at the vertical gap (4203).

**36.** The solar panel according to claim 35, wherein the battery string (4200) further comprises a welding strip (4202) electrically connecting the adjacent cells (4201) in a vertical direction and passing through the transverse gap (4204).

**37.** The solar panel according to claim 36, wherein:
two inner transverse frame bars (4121) are arranged at the transverse gap (4204);
the two inner transverse frame bars (4121) are stacked together and spaced apart from each other; and
the welding strip (4202) vertically passes through a gap between the two inner transverse frame bars (4121).

**38.** The solar panel according to claim 33, wherein:
each of the plurality of vertical frame bars (4110) is provided with a first mortise-tenon portion (4141), and each of the plurality of transverse frame bars (4120) is provided with a second mortise-tenon portion (4142); and/or
each of the plurality of transverse frame bars (4120) is provided a the first mortise-tenon portion (4141), and each of the plurality of vertical frame bars (4110) is provided with a second mortise-tenon portion (4142); and
the first mortise-tenon portion (4141) and the second mortise-tenon portion (4142) are connected to each other in a tenon-mortise manner.

**39.** The solar panel according to claim 38, wherein:
the first mortise-tenon portion (4141) is constructed as a trapezoidal protrusion, a long bottom side of the trapezoidal protrusion being arranged to face outwards; and
the second mortise-tenon portion (4142) is correspondingly constructed as a trapezoidal recess matching with the trapezoidal protrusion, a long bottom side of the trapezoidal recess being arranged to face inwards.

**40.** The solar panel according to any one of claims 33 to 39, wherein a thickness of each of the plurality of vertical frame bars (4110) and a thickness of each of the plurality of transverse frame bars (4120) are both greater than or equal to a thickness of the battery string (4200).

**41.** The solar panel according to any one of claims 33 to 39, wherein the vertical frame bars (4110) and/or the transverse frame bars (4120) have mounting holes, the front plate (4300), the back plate (4400), and/or external components being connected to each other by fasteners passing through the mounting holes.

**42.** The solar panel according to any one of claims 33 to 39, further comprising an adhesive film (4500),
wherein the front plate (4300) and/or the back plate (4400) are bonded and fixed to the battery layer by the adhesive film (4500).
